# EUROPÄISCHE PATENTANMELDUNG

(11) **EP 0 698 967 A2**
(43) Veröffentlichungstag der Anmeldung: **28.02.1996**
(21) Anmeldenummer: 95113041.8
(22) Anmeldetag: 18.08.1995
(51) Int. Cl.: H03K 19/00

(54) **Schaltungsanordnung mit mindestens zwei unterschiedlichen Logikfamilien zugehörigen Schaltkreisen**

(30) Priorität: 24.08.1994 DE 4430053
(71) Anmelder: SIEMENS AKTIENGESELLSCHAFT, D-80333 München (DE)
(72) Erfinder: Hachinger, Manfred, Dipl.-Ing., D-85778 Amperpettenbach (DE)

(57) **Zusammenfassung**

Die Ausgangsstufen dieser Schaltkreise (S1, S2) verfügen über Konstantströme mit unterschiedlichen Richtungen liefernde Konstantstromquellen, die mit einem festgelegten Abschlußwiderstand (Zo) abgeschlossen sind. Dabei ist vorgesehen, daß die mindestens zwei Schaltkreise ausgangsseitig derart gekoppelt sind, daß deren Abschlußwiderstände (Zo) mit ihren vom jeweiligen Schaltkreis wegführenden Anschlüssen über einen Koppel-Widerstand (R3) miteinander verbunden sind.

## Beschreibung

Die Erfindung betrifft eine Schaltungsanordnung gemäß Oberbegriff des Patentanspruches 1.

Bei derartigen Schaltungsanordnungen, in welchen beispielsweise "schnelle" Schaltkreise unterschiedlicher Logikfamilien eingesetzt sind, treten bei einer Forderung nach einer niederohmigen Leitungsanpassung der Schaltkreisausgänge, wie dies beispielsweise bei Leitungstreibern der Fall ist, ohne spezielle Gegenmaßnahmen relativ hohe Verlustleistungen auf, insbesondere bei Verwendung von ECL-Schaltkreisen. Eine mögliche Gegenmaßnahme könnte darin bestehen, daß eine Leitungsanpassung unter Verwendung von Hilfsspannungen realisiert wird. Damit ist jedoch ein zuweilen unerwünschter schaltungstechnischer Aufwand verbunden.

Es ist nun Aufgabe der vorliegenden Erfindung, einen Weg zu zeigen, wie eine Schaltungsanordnung gemäß Oberbegriff des Patentanspruches 1 ausgebildet werden kann, um eine Reduzierung der Verlustleistung ohne Verwendung zusätzlicher Hilfsspannungen erreichen zu können.

Gelöst wird diese Aufgabe durch die im Patentanspruch 1 angegebenen schaltungstechnischen Merkmale. Die Erfindung bringt dabei den Vorteil mit sich, daß die Reduzierung der Verlustleistung mit einem relativ geringen schaltungstechnischen Aufwand, nämlich unter Einsatz lediglich eines zusätzlichen Widerstandes, erzielbar ist. Der Einsatz eines einzigen Widerstandes ist immer dann ausreichend, wenn die Strombilanz zwischen dem den Widerstand zugeführten Strom und dem von diesem Widerstand abfließenden Strom ausgeglichen ist.

Zwechmäßige Ausgestaltungen der Schaltungsanordnung gemäß der vorliegenden Erfindung, insbesondere auch für den Fall einer nichtausgeglichenen Strombilanz, ergeben sich aus den Patentansprüchen 2 bis 4.

Die vorliegende Erfindung wird nachfolgend anhand von Zeichnungen beispielsweise näher erläutert.
- FIG 1: zeigt in schematischer Form eine Schaltungsanordnung nach dem Stand der Technik und
- FIG 2: zeigt in schematischer Form eine Schaltungsanordnung gemäß der vorliegenden Erfindung.

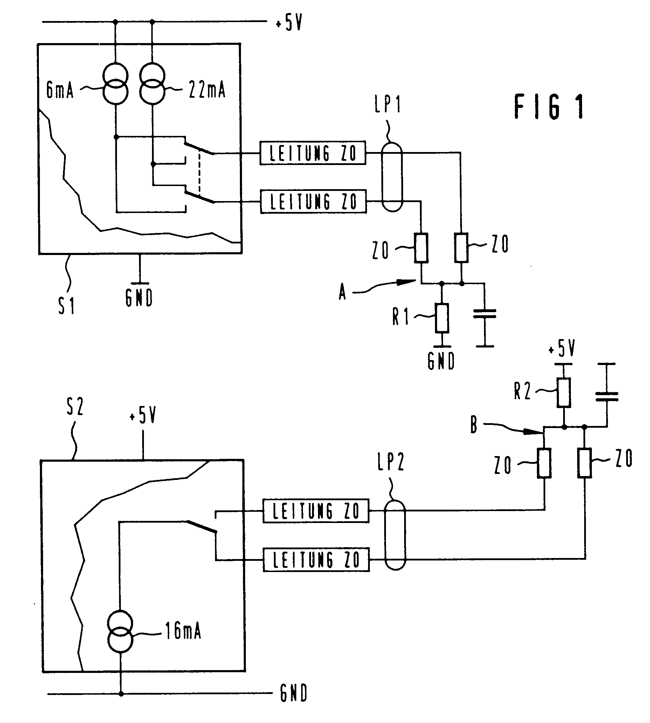

In FIG 1 ist eine Schaltungsanordnung nach dem Stand der Technik dargestellt, welcher zwei, unterschiedlichen Logikfamilien angehörende Schaltkreise S1 und S2 zugehörig sein mögen, von welchen jeweils lediglich ein Ersatzbild der Ausgangsstufe angegeben ist. Bei dem Schaltkreis S1 möge es sich dabei um einen ECL-Schaltkreis handeln, welcher mit Versorgungsspannungen +5V und OV (Masse) betrieben wird und welcher an seinen Komplementärausgängen jeweils eine an die Versorgungsspannung +5V angeschlossene Konstantstromquelle aufweist. Der von der jeweiligen Konstantstromquelle bereitgestellte Strom weist damit eine aus dem Schaltkreis hinaus weisende Richtung (positive Richtung) auf. Demgegenüber ist der Schaltkreis S2 mit den Versorgungsspannungen +5V und OV betrieben, an dessen Koplementärausgängen eine mit OV verbundene Konstantstromquelle vorhanden ist, welche einen Strom mit einer in den Schaltkreis hinein weisenden Richtung (negative Richtung) bereitstellt.

Die Schaltkreise S1 und S2 sind jeweils über zwei Ausgänge mit einem Leitungspaar LP1 bzw. LP2 verbunden, deren beide Leitungen jeweils einen Wellenwiderstand Zo aufweisen. Das jeweilige Leitungspaar ist dabei durch zwei miteinander verbundene Abschlußwiderstände Zo abgeschlossen, wobei im Falle des Leitungspaares LP1 der Verbindungspunkt A der Abschlußwiderstände über einen Widerstand R1 und einen nicht näher bezeichneten Kondensator an Masse (0V) gelegt ist. Bei dem Leitungspaar LP2 ist dagegen der Verbindungspunkt B der Abschlußwiderstände Zo über einen Widerstand R2 mit +5V und über einen nicht näher bezeichneten Kondensator mit Masse verbunden. An den Widerständen treten dabei insbesondere bei niedrigen Wellenwiderständen der Leitungen hohe Verlustleistungen auf.

Die gerade genannten Kondensatoren dienen im übrigen lediglich zur Unterdrückung von hochfrequenten Störsignalen an den erwähnten Verbindungspunkten.

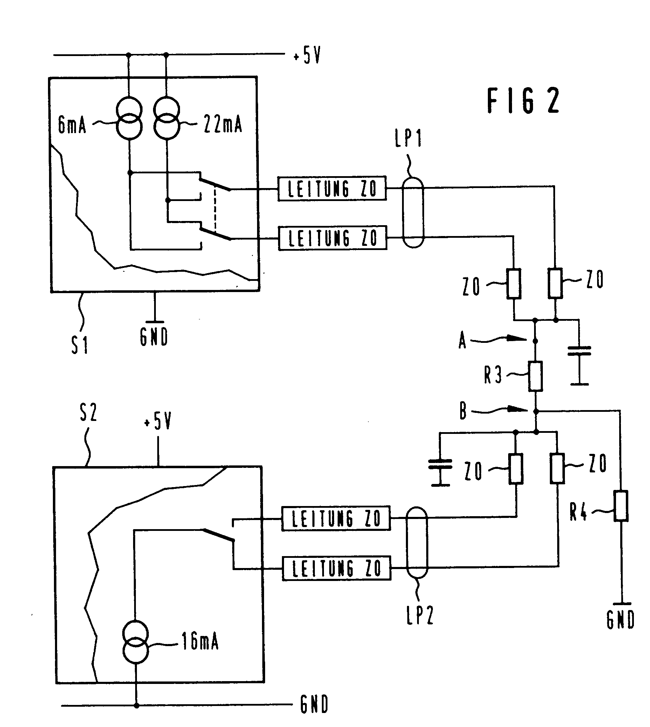

Die zuvor erwähnten, beim Stand der Technik auftretenden hohen Verlustleistungen werden durch eine in FIG 2 dargestellte Schaltungsanordnung vermieden. Diese Schaltungsanordnung entspricht im wesentlichen der in FIG 1 dargestellten Schaltungsanordnung. Ein Unterschied besteht lediglich darin, daß die Verbindungspunkte A und B der Abschlußwiderstände Zo nunmehr über einen Widerstand R3 miteinander verbunden sind. Damit verteilt sich beispielsweise die ursprünglich an dem Widerstand R1 (FIG 1) auftretende Verlustleistung auf den Widerstand R3 und die Ausgänge des Schaltkreises S2 mit den zugehörigen Abschlußwiderständen. Für die gesamte ausgangsseitige Beschaltung der Schaltkreise S1 und S2 ist damit lediglich dieselbe Leistung erforderlich wie für den Schaltkreis S1 in der herkömmlichen, in FIG 1 dargestellten Schaltung allein.

Die Verwendung eines einzigen Widerstandes R3 ist immer dann ausreichend, wenn die Summe der diesem zugeführten Ströme gleich der Summe der abfließenden Ströme ist, d.h. wenn die Strombilanz ausgeglichen ist.

In FIG 2 ist als Beispiel angenommen, daß dem Widerstand R3 von dem Schaltkreis S1 her ein Summenstrom zugeführt ist, der den von dem Schaltkreis S2 aufnehmbaren Summenstrom überschreitet. Nach dem Beispiel liefert der Schaltkreis S1 einen Summenstrom von 28 mA, während der Schaltkreis S2 lediglich einen Summenstrom von 16 mA aufzunehmen vermag. Für diesen Fall ist an dem Verbindungspunkt B ein weiterer, mit Masse verbundener Widerstand R4 angeschlossen, über welchen der Differenzstrom abfließen kann. Im entgegengesetzten Fall, d.h. wenn die Konstantstromquelle des Schaltkreises S2 für einen höheren Strom ausgelegt ist als der von dem Schaltkreis S1 her bereitgestellte Summenstrom, kann der Widerstand R4 über den Verbindungspunkt B oder A beispielsweise mit der Versorgungsspannung des Schaltkreises S1 (+5V) verbunden sein. Allgemein gilt, daß dieser Widerstand R4 mit einem seiner Anschlüsse an den Widerstand R3 angeschlossen ist, während der verbleibende Anschluß derart mit Masse bzw. einer der Versorgungsspannungen der Schaltkreise S1 und S2 verbunden ist, daß die Strombilanz zwischen dem dem Widerstand R3 zugeführten Summenstrom und dem abfließenden Summenstrom ausgeglichen ist.

Bei dem in FIG 2 angegebenen Ausführungsbeispiel sind im übrigen die Widerstandswerte für Zo mit 50 Ω, für R3 mit 46 Ω und für R4 mit 140 Ω festgelegt.

Die Schaltungsanordnung gemäß FIG 2 kann auch derart modifiziert sein, daß an dem Verbindungspunkt A eine Mehrzahl von dem Schaltkreis S1 entsprechenden Schaltkreisen und an dem Verbindungspunkt B eine Mehrzahl von dem Schaltkreis S2 entsprechenden Schaltkreisen angeschlossen ist. Durch eine solche Zusammenfassung mehrerer Schaltkreise an den Verbindungspunkten A und B wird die Verlustleistungsbilanz der gesamten Schaltungsanordnung weiter verbessert, weil die Stromsummen an A und B besser ausgeglichen werden können.

Im übrigen können die Verbindungspunkte A und B auch in Subknoten aufgespalten und räumlich verteilt werden, um die einzelnen räumlich getrennten Schaltkreise an die Verbindungspunkte A und B anschließen zu können. Im differentiellen Betrieb verharren die einzelnen Subknoten im allgemeinen auf einem ausreichend konstanten Potential. Sollte jedoch unter bestimmten Bedingungen diese Konstanz beispielsweise durch Einstreuung von hochfrequenten Signalen nicht ausreichend sein, so könnten die einzelnen verteilten Subknoten mit den in FIG 2 dargestellten Kondensatoren entsprechenden Kondensatoren gestützt sein.

Abschließend sei noch darauf hingewiesen, daß die vorliegende Erfindung nicht nur für eine Kombination von Schaltkreisen, wie sie in FIG 2 angegeben ist, einsetzbar ist. Vielmehr ist sie allgemein immer dann anwendbar, wenn Schaltkreise unterschiedlicher Logikfamilien vorgesehen sind und deren Ausgangsstufen über Konstantstromquellen verfügen, die Konstantströme mit unterschiedlichen Richtungen liefern und die mit einem festgelegten Abschlußwiderstand abgeschlossen sind. Dabei können diese Schaltkreise sowohl für die Abgabe von differentiellen Ausgangssignalen als auch für die Abgabe von nichtdifferentiellen Ausgangssignalen ausgelegt sein. Bei letzterem sind hochpaßbegrenzte Signale mit ausreichender Stützung durch Kondensatoren gemäß FIG 2 vorauszusetzen.

## Patentansprüche

1. Schaltungsanordnung mit mindestens zwei, unterschiedlichen Logikfamilien zugehörigen Schaltkreisen (S1,S2), deren Ausgangstufen über Konstantströme mit unterschiedlichen Richtungen liefernde Konstantstromquellen verfügen, die mit einem festgelegten Abschlußwiderstand (Zo) abgeschlossen sind,
**dadurch gekennzeichnet,**
daß die mindestens zwei Schaltkreise (S1,S2) ausgangsseitig derart gekoppelt sind, daß deren Abschlußwiderstände (Zo) mit ihren vom jeweiligen Schaltkreis wegführenden Anschlüssen über einen Koppel-Widerstand (R3) miteinander verbunden sind.

2. Schaltungsanordnung nach Anspruch 1,
**dadurch gekennzeichnet,**
daß bei Schaltkreisen (S1,S2) mit jeweils einer Komplementärausgangsstufe, an welche Anschlußwiderständen (Zo) angeschlossen sind, die an einem von dem jeweiligen Schaltkreis wegführenden Verbindungspunkt (A bzw.B) miteinander verbunden sind, der Koppel-Widerstand (R3) zwischen den Verbindungspunkten (A,B) der Abschlußwiderstände der mindestens zwei Schaltkreise angeordnet ist.

3. Schaltungsanordnung nach Anspruch 1 oder 2,
**dadurch gekennzeichnet,**
daß an den jeweiligen Anschluß des Koppel-Widerstandes (R3) eine Mehrzahl gleichartiger Schaltkreise (S1,S2) angeschlossen ist.

4. Schaltungsanordnung nach einem der Ansprüche 1 bis 3,
**dadurch gekennzeichnet,**
daß an einem der Anschlüsse des Koppel-Widerstandes (z.B. B) ein weiterer Widerstand (R4) angeschlossen ist, dessen verbleibender Anschluß derart mit Masse bzw. einer der Versorgungsspannungen (+5V) verbunden ist, daß die Strombilanz zwischen dem den Koppel-Widerstand zugeführten Strom und dem von diesem Koppel-Widerstand abfließenden Strom ausgeglichen ist.
